(19) Europäisches Patentamt
European Patent Office
Office européen des brevets

(11) **EP 3 204 728 B1**

(12) **EUROPÄISCHE PATENTSCHRIFT**

(45) Veröffentlichungstag und Bekanntmachung des Hinweises auf die Patenterteilung:
**12.02.2020  Patentblatt 2020/07**

(21) Anmeldenummer: **15778896.9**

(22) Anmeldetag: **29.09.2015**

(51) Int Cl.:
**G01D 5/20** (2006.01)

(86) Internationale Anmeldenummer:
**PCT/EP2015/072370**

(87) Internationale Veröffentlichungsnummer:
**WO 2016/055301 (14.04.2016 Gazette 2016/15)**

(54) **SENSORANORDNUNG ZUR BERÜHRUNGSLOSEN ERFASSUNG VON DREHWINKELN AN EINEM ROTIERENDEN BAUTEIL**

SENSOR ARRANGEMENT FOR THE CONTACTLESS SENSING OF ANGLES OF ROTATION ON A ROTATING PART

ENSEMBLE CAPTEUR POUR LA DÉTECTION SANS CONTACT D'ANGLES DE ROTATION SUR UN ÉLÉMENT EN ROTATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **09.10.2014  DE 102014220454**

(43) Veröffentlichungstag der Anmeldung:
**16.08.2017  Patentblatt 2017/33**

(73) Patentinhaber: **Robert Bosch GmbH**
**70442 Stuttgart (DE)**

(72) Erfinder:
• LEIDICH, Stefan
**71277 Rutesheim (DE)**
• AMELING, Ralf
**73434 Aalen (DE)**

(56) Entgegenhaltungen:
EP-A2- 1 083 408          EP-A2- 1 975 570
DE-A1-102007 037 217      DE-U1- 9 105 145

## Beschreibung

Die Erfindung geht aus von einer Sensoranordnung zur berührungslosen Erfassung von Drehwinkeln nach der Gattung des unabhängigen Patentanspruchs 1 und des unabhängigen Patentanspruchs 2.

Es sind verschiedene induktive Drehwinkelsensoren aus dem Stand der Technik bekannt. Mehrheitlich wird die Kopplung zwischen einer Erregerspule und einer oder mehrerer Sensorspulen durch die Drehwinkellage eines Koppelelements (Target) beeinflusst. Die Auswertung von Koppelfaktoren erfordert eine aufwändige Elektronik. Die Form des Drehwinkelsignalverlaufs hängt generell stark von der Geometrie und Anordnung der verwendeten Sensorspulen und Targets ab.

Die DE 197 38 836 A1 offenbart beispielsweise einen induktiven Winkelsensor mit einem Statorelement, einem Rotorelement und einer Auswerteschaltung. Das Statorelement weist eine mit einer periodischen Wechselspannung beaufschlagte Erregerspule sowie mehrere Empfangsspulen auf. Das Rotorelement gibt die Stärke der induktiven Kopplung zwischen Erregerspule und Empfangsspulen in Abhängigkeit seiner Winkelposition relativ zum Statorelement vor. Die Auswerteschaltung bestimmt die Winkelposition des Rotorelements relativ zum Statorelement aus den in den Empfangsspulen induzierten Spannungssignalen.

Aus der EP 1 975 570 A2 ist ein induktives Wirbelstrombetätigungselement bekannt.

Aus der EP 1 083 408 A2 ist eine induktive Messeinrichtung zur berührungslosen Erfassung der relativen Drehposition bekannt.

Aus der DE 10 2007 037 217 A1 ist eine induktive Messeinrichtung zur berührungslosen Erfassung der relativen Drehposition zwischen zwei Körpern mit diametral angeordneten Spulen bekannt.

Aus der DE 91 05 145 U1 ist eine gattungsgemäße Sensoranordnung zur berührungslosen Erfassung von Drehwinkeln an einem rotierenden Bauteil bekannt. Das rotierende Bauteil ist mit einem scheibenförmigen Target gekoppelt, welches mindestens zwei Metallflächen aufweist und in Verbindung mit einer Spulenanordnung, welche mindestens drei flächige Detektionsspulen aufweist, mindestens eine Information zur Ermittlung des aktuellen Drehwinkels des rotierenden Bauteils erzeugt. Die mindestens drei flächigen Detektionsspulen sind gleichmäßig verteilt am Umfang eines Kreises angeordnet, und die mindestens zwei Metallflächen beeinflussen durch Wirbelstromeffekte die Induktivitäten der flächigen Detektionsspulen in Abhängigkeit vom Überdeckungsgrad. Eine Auswerte- und Steuereinheit erzeugt im Wesentlichen sinusförmige Auswertesignale, welche die Induktivitätsänderungen der Detektionsspulen repräsentieren, und wertet diese zur Berechnung des Drehwinkels aus.

Offenbarung der Erfindung

Die erfindungsgemäße Sensoranordnung zur berührungslosen Erfassung von Drehwinkeln mit den Merkmalen des unabhängigen Patentanspruchs 1 oder mit den Merkmalen des unabhängigen Patentanspruchs 2 hat demgegenüber den Vorteil, dass die Messung eines Drehwinkels durch Bestimmung der Induktivität von einer Mehrzahl von Einzelspulen, vorzugsweise drei oder sechs kreisförmig angeordnete Spulen, möglich ist. In vorteilhafter Weise erzeugt die Auswerte- und Steuereinheit Auswertesignale mit einem Signalverlauf, welcher einem 3-Phasen Sinussignal sehr ähnlich ist, so dass die Auswertung mit einfachen Rechenregeln möglich ist. Die einzelnen Detektionsspulen weisen eine spezielle Geometrie auf.

Ein dreiphasiger sinusförmiger Signalverlauf hat den Vorteil, dass aus den gemessenen Induktivitäten der einzelnen Detektionsspulen mit vergleichsweise einfachen Rechenvorschriften auf den Drehwinkel geschlossen werden kann (Scott-T-Transformation). In vorteilhafter Weise ist die Berücksichtigung von mechanischen Toleranzen, wie beispielsweise Versatz oder Verkippung des Targets, durch die einfachen mathematischen Zusammenhänge einfach implementierbar. Sinus-, Cosinus und/oder Tangensfunktionen sowie deren Umkehrfunktionen lassen sich mit einem Mikrocontroller, welcher Teil der Auswerte- und Steuereinheit ist, vergleichsweise einfach verarbeiten.

Der dreiphasige Signalverlauf wird durch eine kreisförmige Anordnung von drei oder sechse Spulen erreicht. Je nach Anzahl der Metallflächen des Targets erhält man eine Periodizität von 90° oder 180°. So kann eine Periodizität von 90° umgesetzt werden, wenn das Target vier Metallflächen aufweist. Weist das Target nur zwei Metallflächen auf, kann eine Periodizität von 180° umgesetzt werden.

Um ein sinusförmiges Signal zu erhalten, ist die Geometrie der Spule entsprechend angepasst. Ausführungsformen der erfindungsgemäßen Sensoranordnung umfassen eine Spulenanordnung, bei welcher die Abstände zwischen den Leiterbahnen der einzelnen Windungen der einzelnen Detektionsspulen bzw. Teilspulen so angepasst sind, dass sich die Induktivität der Spule beim Überstreichen der Metallflächen des Targets so ändert, dass ein sinusförmiger Verlauf des Drehwinkelsignals entsteht.

Ausführungsformen der vorliegenden Erfindung stellen eine Sensoranordnung zur berührungslosen Erfassung von Drehwinkeln an einem rotierenden Bauteil zur Verfügung, welches mit einem scheibenförmigen Target gekoppelt ist, welches mindestens eine Metallfläche aufweist und in Verbindung mit einer Spulenanordnung, welche mindestens eine flächige Detektionsspule aufweist, mindestens eine Information zur Ermittlung des aktuellen Drehwinkels des rotierenden Bauteils erzeugt. Hierbei umfasst die Spulenanordnung drei flächige Detektionsspulen, welche gleichmäßig verteilt am Umfang eines Kreises angeordnet sind, und das rotierende Target umfasst mindestens zwei Metallflächen, welche durch Wirbelstromeffekte die Induktivitäten der flächigen Detektionsspulen in Abhängigkeit vom Überdeckungsgrad beeinflussen, wobei eine Auswerte- und Steuereinheit im Wesentlichen sinusförmige Auswertesignale, welche die Induktivitätsänderungen der Detektionsspulen repräsentieren, erzeugt und zur Berechnung des Drehwinkels auswertet. Hierbei sind die flächigen Detektionsspulen jeweils als gleichförmige Kreissegmente und/oder Kreisringsegmente mit einem vorgegebenen Öffnungswinkel im Bereich von 100° bis 120° ausgeführt.

Zudem wird eine Sensoranordnung zur berührungslosen Erfassung von Drehwinkeln an einem rotierenden Bauteil vorgeschlagen, welches mit einem scheibenförmigen Target gekoppelt ist, welches mindestens eine Metallfläche aufweist und in Verbindung mit einer Spulenanordnung, welche mindestens eine flächige Detektionsspule aufweist, mindestens eine Information zur Ermittlung des aktuellen Drehwinkels des rotierenden Bauteils erzeugt. Hierbei umfasst die Spulenanordnung drei flächige Detektionsspulen, welche gleichmäßig verteilt am Umfang eines Kreises angeordnet sind, und das rotierende Target umfasst mindestens zwei Metallflächen, welche durch Wirbelstromeffekte die Induktivitäten der flächigen Detektionsspulen in Abhängigkeit vom Überdeckungsgrad beeinflussen, wobei eine Auswerte- und Steuereinheit im Wesentlichen sinusförmige Auswertesignale, welche die Induktivitätsänderungen der Detektionsspulen repräsentieren, erzeugt und zur Berechnung des Drehwinkels auswertet. Hierbei weisen die flächigen Detektionsspulen jeweils zwei Teilspulen mit entgegengesetztem Wicklungssinn auf, welche einander gegenüberliegend am Umfang des Kreises angeordnet sind. Zudem sind die flächigen Teilspulen jeweils als gleichförmige Kreissegmente und/oder Kreisringsegmente mit einem vorgegebenen Öffnungswinkel im Bereich von 50° bis 60° ausgeführt. Durch den entgegengesetzten Wicklungssinn der beiden Teilspulen ergeben sich vorteilhafte EMV-Eigenschaften in Bezug auf Emission und Störsignaleinkopplung. Des Weiteren ergeben sich durch die gegenüberliegende Anordnung der Teilspulen an einem Kreisumfang geringe Empfindlichkeiten gegenüber Montagetoleranzen

Durch die in den abhängigen Ansprüchen aufgeführten Maßnahmen und Weiterbildungen sind vorteilhafte Verbesserungen der im unabhängigen Patentanspruch 1 und im unabhängigen Patentanspruch 2 angegebenen Sensoranordnung zur berührungslosen Erfassung von Drehwinkeln möglich.

In weiterer vorteilhafter Ausgestaltung der erfindungsgemäßen Sensoranordnung kann ein Abstand zwischen zwei kreisbogenförmig verlaufenden Leiterbahnabschnitten der einzelnen Detektionsspule oder Teilspule möglichst klein und ein Abstand zwischen zwei radial verlaufenden Leiterbahnabschnitten der einzelnen Detektionsspule oder Teilspule so gewählt werden, dass sich die radial verlaufenden Leiterbahnabschnitte möglichst gleichmäßig über die zu Verfügung stehende Fläche der einzelnen Detektionsspule oder Teilspule verteilen. Dadurch kann eine ausreichend große Induktivität für die einzelnen Detektionsspulen oder Teilspulen erzielt werden, wodurch die Erfassung und Auswertung der Induktivitätsänderungen in vorteilhafter Weise erleichtert werden kann.

In weiterer vorteilhafter Ausgestaltung der erfindungsgemäßen Sensoranordnung können die Metallflächen jeweils als gleichförmige Kreissegmente und/oder Kreisringsegmente mit einem vorgegebenen Öffnungswinkel ausgeführt werden. Der Öffnungswinkel der Metallflächen kann in Abhängigkeit von der Anzahl der Metallflächen jeweils einen Wert im Bereich von 50° bis 120° aufweisen.

Zur Erzeugung von drei phasenverschobene im Wesentlichen sinusförmige Auswertesignalen kann das zugehörige Target beispielsweise vier gleichmäßig verteilt am Umfang eines Kreises angeordnete Metallflächen aufweisen, welche jeweils einen Öffnungswinkel von 60° aufweisen. Die Auswerte- und Steuereinheit erzeugt aus den durch die Rotationsbewegung des Targets bewirkten Induktivitätsänderungen der drei Detektionsspulen drei phasenverschobene im Wesentlichen sinusförmige Auswertesignale und wertet diese zur Berechnung des Drehwinkels in einem Eindeutigkeitsbereich von 90° aus. Um den Eindeutigkeitsbereich auf 180° zu vergrößern, kann das Target zwei einander gegenüberliegende am Umfang eines Kreises angeordnete Metallflächen aufweisen, welche jeweils einen Öffnungswinkel von 120° aufweisen, wobei die Auswerte- und Steuereinheit aus den durch die Rotationsbewegung des Targets bewirkten Induktivitätsänderungen der drei Detektionsspulen drei phasenverschobene im Wesentlichen sinusförmige Auswertesignale erzeugt und diese zur Berechnung des Drehwinkels in einem Eindeutigkeitsbereich von 180° auswertet.

Ausführungsbeispiele der Erfindung sind in den Zeichnungen dargestellt und werden in der nachfolgenden Beschreibung näher erläutert. In den Zeichnungen bezeichnen gleiche Bezugszeichen Komponenten bzw. Elemente, die gleiche bzw. analoge Funktionen ausführen.

Kurze Beschreibung der Zeichnungen

Fig. 1 zeigt eine schematische Draufsicht auf ein erstes Ausführungsbeispiel einer erfindungsgemäßen Sensoranordnung zur berührungslosen Erfassung von Drehwinkeln.

Fig. 2 zeigt eine schematische Draufsicht auf ein erstes Ausführungsbeispiel einer Spulenanordnung für die erfindungsgemäße Sensoranordnung aus Fig. 1.

Fig. 3 zeigt eine schematische Draufsicht auf eine Detektionsspule für die Spulenanordnung aus Fig. 2.

Fig. 4 zeigt ein Kennliniendiagramm der von der erfindungsgemäßen Sensoranordnung zur berührungslosen Erfassung von Drehwinkeln aus Fig. 1 erzeugten Auswertesignale.

Fig. 5 zeigt eine schematische Draufsicht auf ein zweites Ausführungsbeispiel einer erfindungsgemäßen Sensoranordnung zur berührungslosen Erfassung von Drehwinkeln.

Fig. 6 zeigt eine schematische Draufsicht auf ein zweites Ausführungsbeispiel einer Spulenanordnung für die erfindungsgemäße Sensoranordnung aus Fig. 5.

Fig. 7 zeigt eine schematische Draufsicht auf eine Detektionsspule für die Spulenanordnung aus Fig. 6.

Fig. 8 zeigt ein Kennliniendiagramm der von der erfindungsgemäßen Sensoranordnung zur berührungslosen Erfassung von Drehwinkeln aus Fig. 5 erzeugten Auswertesignale.

Ausführungsformen der Erfindung

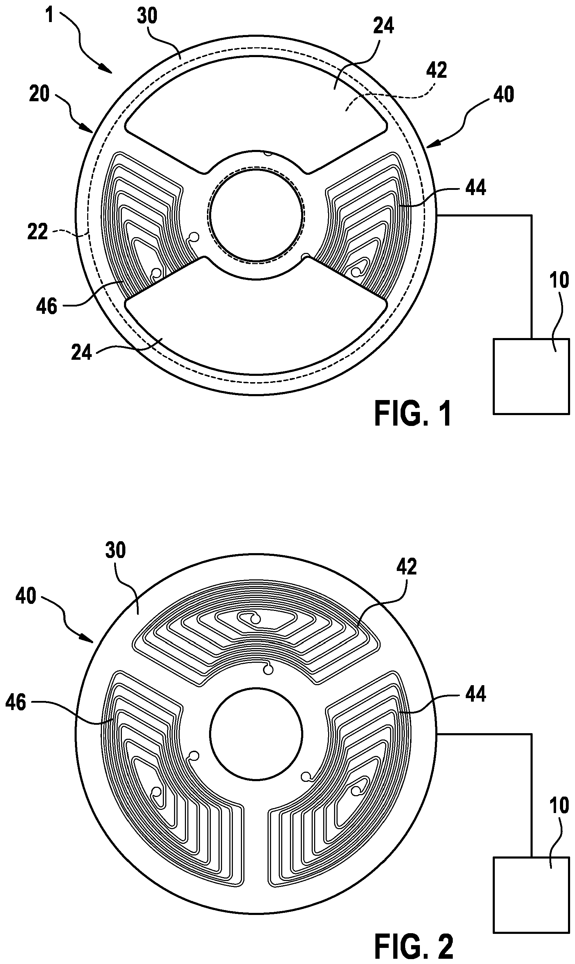

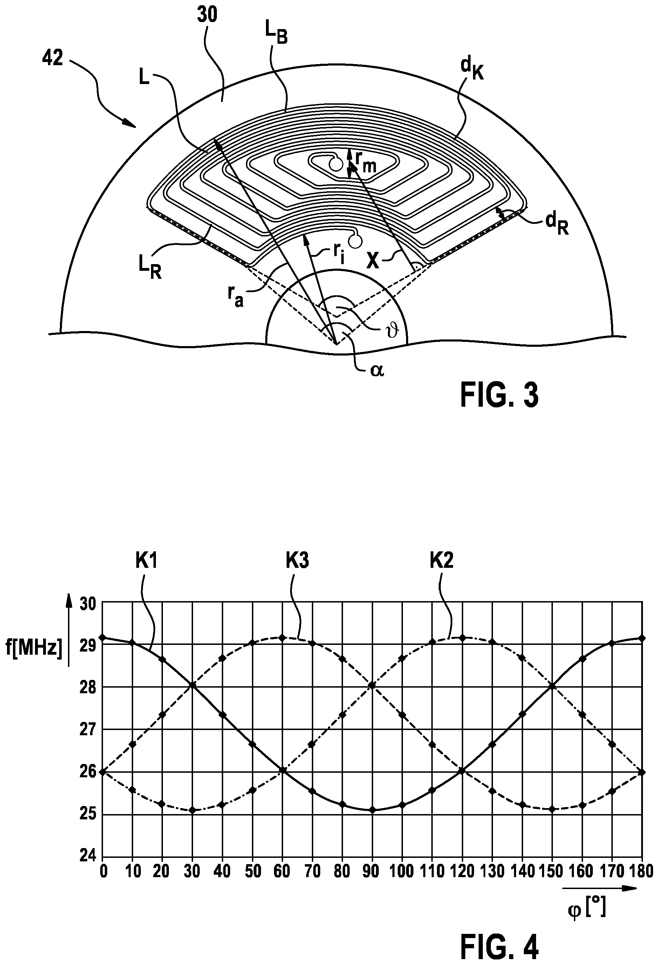

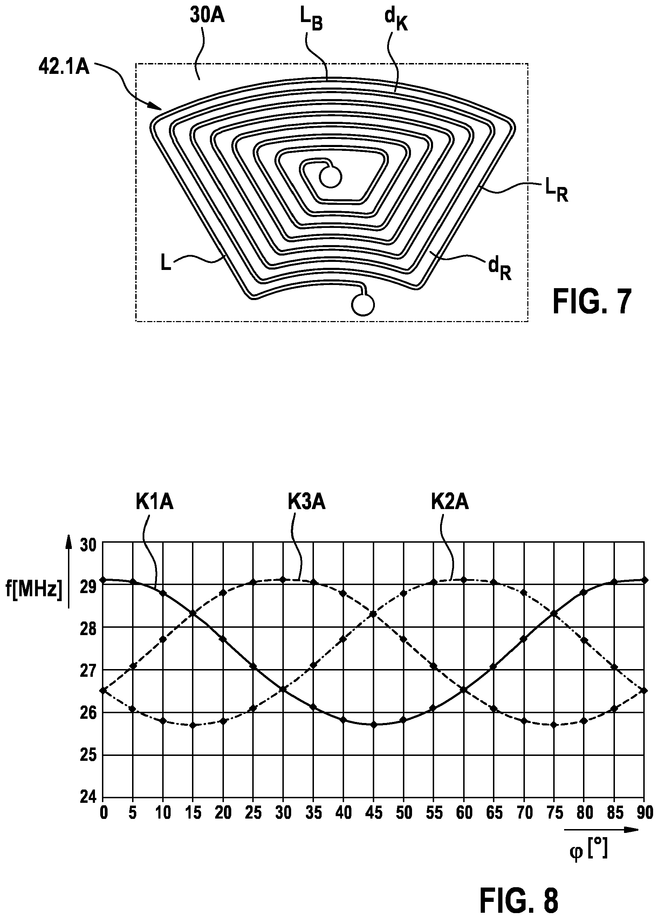

Wie aus Fig. 1 bis 8 ersichtlich ist, umfassen die dargestellten Ausführungsbeispiel einer erfindungsgemäßen Sensoranordnung 1, 1A zur berührungslosen Erfassung von Drehwinkeln an einem rotierenden Bauteil jeweils ein mit dem rotierenden Bauteil gekoppeltes Target 20, 20A, welches einen ringscheibenförmigen Grundkörper 22, 22A mit mindestens einer Metallfläche 24, 24A aufweist, und eine Spulenanordnung 40, 40A mit mindestens einer flächige Detektionsspule 42, 44, 46, 42A, 44A, 46A, welche auf einer runden Leiterplatte 30, 30A angeordnet ist. Das Target 20, 20A erzeugt in Verbindung mit der Spulenanordnung 40, 40A mindestens eine Information zur Ermittlung des aktuellen Drehwinkels des rotierenden Bauteils. Erfindungsgemäß umfasst die Spulenanordnung 40, 40A drei flächige Detektionsspulen 42, 44, 46, 42A, 44A, 46A, welche gleichmäßig verteilt am Umfang eines Kreises angeordnet sind, und das rotierende Targets 20, 20A umfasst mindestens zwei Metallflächen 24, 24A, welche durch Wirbelstromeffekte die Induktivitäten der flächigen Detektionsspulen 42, 44, 46, 42A, 44A, 46A in Abhängigkeit vom Überdeckungsgrad beeinflussen. Hierbei erzeugt eine Auswerte- und Steuereinheit 10 im Wesentlichen sinusförmige Auswertesignale K1, K2, K3, K1A, K2A, K3A, welche die Induktivitätsänderungen der Detektionsspulen 42, 44, 46, 42A, 44A, 46A repräsentieren, und wertet diese zur Berechnung des Drehwinkels aus. Die Auswertesignale K1, K2, K3, K1A, K2A, K3A werden nachfolgend unter Bezugnahme auf Fig. 3 und 8 näher beschrieben.

Wie aus Fig. 1 bis 8 weiter ersichtlich ist, ist die Spulenanordnung 40, 40A in den dargestellten Ausführungsformen auf einer runden Leiterplatte 30, 30A angeordnet und mit einer Auswerte- und Steuereinheit 10 elektrisch verbunden. Selbstverständlich muss die Leiterplatte 30, 30A nicht rund sein, die Leiterplatte 30, 30A kann auch eine andere geeignete Form aufweisen. Der in den Zeichnungen transparent dargestellte ringscheibenförmige Grundkörper 22, 22A des Targets 20, 20A ist mit einem vorgegebenen gleichbleibenden axialen Abstand über bzw. unter der Leiterplatte 30, 30A angeordnet. Bei den dargestellten Ausführungsbeispielen kann das nicht näher dargestellte rotierende Bauteil eine Welle sein, welche mit einem ausreichenden seitlichen Spiel durch die kreisförmige Öffnung in der Leiterplatte 30, 30A geführt ist und drehfest mit dem Grundkörper 22, 22A des Targets 20, 20A verbunden ist.

Wie aus Fig. 1 bis 3 weiter ersichtlich ist, umfasst das erste Ausführungsbeispiel der Spulenanordnung 40 drei über den Umfang der kreisförmigen Spulenanordnung 40 verteilt angeordnete Detektionsspulen 42, 44, 46. Wie aus Fig. 1 weiter ersichtlich ist, umfasst das Target 20 des dargestellten ersten Ausführungsbeispiels der erfindungsgemäßen Sensoranordnung 1 zwei kreisringsegmentförmige Metallflächen 24, welche jeweils einen Öffnungswinkel mit einem Wert im Bereich von 100° bis 120° aufweisen. Wie insbesondere aus Fig. 2 ersichtlich ist, sind die flächigen Detektionsspulen 42, 44, 46 jeweils als gleichförmige Kreisringsegmente mit einem vorgegebenen Öffnungswinkel ausgeführt, welcher einen Wert im Bereich von 100° bis 120° aufweist.

Wie aus Fig. 3 weiter ersichtlich ist, weisen Leiterbahnen L mit der Dicke B, welche die jeweilige Wicklung der zugehörigen Detektionsspule 42, 44, 46 ausbilden, von denen beispielhaft eine erste Detektionsspule 42 dargestellt ist, kreisbogenförmige Leiterbahnabschnitte $L_B$ und radial verlaufende Leiterbahnabschnitte $L_R$ auf. Ein Abstand $d_K$, welchen die kreisbogenförmig verlaufenden Leiterbahnabschnitte $L_R$ zueinander haben, ist vorzugsweise möglichst klein gewählt, um möglichst viele Spulenwindungen N auf der zur Verfügung stehenden Fläche der Detektionsspule 42, 44, 46 unterzubringen. Die maximale Anzahl N der Spulenwindungen kann näherungsweise mit der Gleichung (1) berechnet werden.

$$N \approx \frac{\frac{1}{2}(r_a - r_i - r_m) + d_k}{B + d_k} \qquad (1)$$

Hierbei bezeichnen $r_a$ einen Außenradius, $r_i$ einen Innenradius der korrespondierenden Detektionsspule 42, 44, 46, $r_m$ eine radiale Ausdehnung einer freien Fläche im Zentrum der korrespondierenden Detektionsspule 42, 44, 46 und B die Leiterbahnbreite. Sowohl die minimale Leiterbahnbreite B als auch der minimale Abstand $d_K$ zwischen zwei kreisbogenförmigen Leiterbahnabschnitte $L_B$ betragen beispielsweise 125 $\mu$m. Die Werte für die übrigen Größen betragen beispielsweise $r_a$ = 8,35 mm, $r_i$ = 4 mm und $r_m$ = 0,75 mm. Daraus folgt mit obiger Formel eine Windungszahl von N = 7,7 für das dargestellte Ausführungsbeispiel.

Der Abstand $d_R$ der radial verlaufenden Leiterbahnabschnitte $L_R$ ist so gewählt, dass sich die radial verlaufenden Leiterbahnabschnitte $L_R$ möglichst gleichmäßig über die gesamte zur Verfügung stehende Fläche der korrespondierenden Detektionsspule 42, 44, 46 verteilen. Der passende Leiterbahnabstand $d_R$ lässt sich mit Gleichung (2) näherungsweise berechnen.

$$d_R = \frac{X}{N} - B \qquad (2)$$

Im dargestellten ersten Ausführungsbeispiel beträgt der Abstand $d_R$ beispielsweise 480 $\mu$m. Eine den senkrechten Abstand zwischen dem Zentrum der Spule und dem äußersten radialen Leiterbahnabschnitte $L_R$ repräsentierende Länge X kann mit Gleichung (3) bestimmt werden.

$$X = \frac{1}{2}(r_i + r_a) \cdot \sin\left(\frac{1}{2}\vartheta\right) - r_i \cdot \sin\left(\frac{1}{2}(\vartheta - \alpha)\right) \qquad (3)$$

Hierbei bezeichnet $\vartheta$ den Winkel, welchen die radial verlaufenden Leiterbahnabschnitte $L_R$ der linken und rechten Spulenhälfte miteinander einschließen, $\alpha$ bezeichnet den Öffnungswinkel der kreisförmigen Leiterbahnabschnitte $L_R$. Im dargestellten ersten Ausführungsbeispiel der Spulenanordnung 40 gilt: $\vartheta$ = 120° und $\alpha$ = 100°.

Wie aus dem zugehörigen Kennliniendiagramm gemäß Fig. 4 ersichtlich ist, verlaufen die drei erzeugten phasenverschobenen Auswertesignale K1, K2, K3 nahezu sinusförmig, wobei die Auswerte- und Steuereinheit 10 ein erstes Auswertesignal K1 durch Auswerten der ersten Detektionsspule 42 erzeugt, ein zweites Auswertesignal K2 durch Auswerten der zweiten Detektionsspule 44 erzeugt und ein drittes Auswertesignal K3 durch Auswerten der dritten Detektionsspule 46 erzeugt. Fig. 1 zeigt beispielhaft die Lage der Targets 20 bei einem Drehwinkel von 0°, wobei die Festlegung per Definition erfolgt. Die Öffnungswinkel der Detektionsspulen 42, 44, 46 betragen jeweils 100° und die Öffnungswinkel der Metallflächen 24 des Targets 20 betragen jeweils 120°. Der Drehwinkelmessbereich beträgt durch die Verwendung von nur zwei Metallflächen 24 180°. In dem dargestellten Kennliniendiagramm gemäß Fig. 4 ist entlang der senkrechten Achse eine Resonanzfrequenz aufgetragen, welche sich durch die Induktivitätsänderung der jeweiligen Detektionsspule 42, 44, 46 verändert. Selbstverständlich können auch andere geeignete messbare physikalische Größen verwendet werden, um Induktivitätsänderung der jeweiligen Detektionsspule 42, 44, 46 zu erfassen und darzustellen.

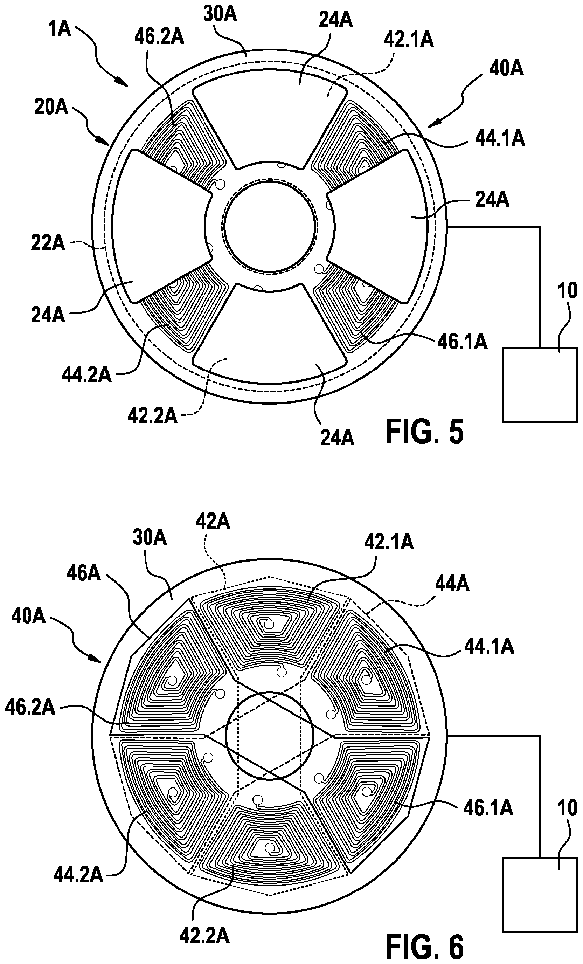

Wie aus Fig. 5 bis 7 weiter ersichtlich ist, umfasst das zweite Ausführungsbeispiel der Spulenanordnung 40A drei über den Umfang der kreisförmigen Spulenanordnung 40A verteilt angeordnete Detektionsspulen 42A, 44A, 46A, welche jeweils in zwei Teilspulen 42.1A, 42.2A, 44.1A, 44.2A, 46.1A, 46.2A aufgeteilt sind. Somit sind insgesamt sechs Teilspulen 42.1A, 42.2A, 44.1A, 44.2A, 46.1A, 46.2A gleichmäßig über den Umfang der kreisförmigen Spulenanordnung 40A verteilt angeordnet. Die beiden Teilspulen 42.1A, 42.2A, 44.1A, 44.2A, 46.1A, 46.2A der jeweiligen Detektionsspulen 42A, 44A, 46A sind jeweils so über den Umfang der kreisförmigen Spulenanordnung 40A verteilt angeordnet, dass laterale Lagetoleranzen in erster Näherung kompensiert werden. Im dargestellten zweiten Ausführungsbeispiel sind die beiden Teilspulen 42.1A, 42.2A, 44.1A, 44.2A, 46.1A, 46.2A der jeweiligen Detektionsspule 42A, 44A, 46A einander gegenüberliegend am Umfang der kreisförmigen Spulenanordnung 40A angeordnet. Der Wicklungssinn der beiden Teilspulen 42.1A, 42.2A, 44.1A, 44.2A, 46.1A, 46.2A der jeweiligen Detektionsspule 42A, 44A, 46A ist entgegengesetzt, so dass das magnetische Feld in einem Abstand ab ca. drei Spulendurchmessern sehr klein ist und sich Störsignaleinkopplungen kompensieren können.

Wie insbesondere aus Fig. 6 ersichtlich ist, sind die flächigen Teilspulen 42.1A, 42.2A, 44.1A, 44.2A, 46.1A, 46.2A jeweils als gleichförmige Kreisringsegmente mit einem vorgegebenen Öffnungswinkel von 50° ausgeführt. In den dargestellten Ausführungsbeispielen besteht eine erste Detektionsspule 42A aus den beiden flächigen Teilspulen 42.1A und 42.2A, eine zweite Detektionsspule 44A besteht aus den beiden flächigen Teilspulen 44.1A und 44.2A und eine dritte Detektionsspule 46A besteht aus den beiden flächigen Teilspulen 46.1A und 46.2A.

Wie aus Fig. 5 weiter ersichtlich ist, umfasst das Target 20A des dargestellten zweiten Ausführungsbeispiels der erfindungsgemäßen Sensoranordnung 1A zur berührungslosen Erfassung von Drehwinkeln an einem rotierenden Bauteil vier kreisringsegmentförmige Metallflächen 24A mit einem Öffnungswinkel von 60°. Fig. 5 zeigt beispielhaft die Lage der Targets 20A bei einem Drehwinkel von 0°, wobei die Festlegung per Definition erfolgt. Es ist offensichtlich, dass eine Verschiebung des Mittelpunkts des Targets 20A in positive y-Richtung (Orientierung entsprechend der Blattebene) zu einer Vergrößerung der Überdeckung der zweiten Teilspule 46.2A der dritten Detektionsspule 46A und zu einer Verkleinerung der Überdeckung der ersten Teilspule 46.1A der dritten Detektionsspule 46A führt. Der gleiche Zusammenhang gilt für die Teilspulen 44.1A und 44.2A der zweiten Detektionsspule 44A. Für die Teilspulen 42.1A und 42.2A der ersten Detektionsspule 42A gilt der Zusammenhang in dieser Stellung des Targets 20A nicht, da durch größere Auslegung des Targets 20A in radialer Richtung generell keine Beeinflussung dieser Teilspulen 42.1A, 42.2A durch eine kleine (<5% des Durchmessers) Verschiebung des Targets 20A in y-Richtung stattfindet.

Es ist möglich, die Induktivität der sechs Teilspulen 42.1A und 42.2A, 44.1A und 44.2A sowie 46.1A und 46.2A einzeln zu messen und die Korrektur entsprechend der nachfolgenden Vorschrift durchzuführen, wobei Lm den berechneten Mittelwert der Induktivität der Teilspule repräsentiert, der sich aus den gemessenen Induktivitäten der Teilspulen 42.1A, 42.2A, 44.1A, 44.2A, 46.1A, 46.2A der jeweiligen Detektionsspule 42A, 44A, 46A ergibt und gemäß Gleichung (4) bestimmt werden kann. Hierbei repräsentieren L1 und L2 jeweils die gemessene Induktivität der korrespondierenden Teilspulen 42.1A, 42.2A, 44.1A, 44.2A, 46.1A, 46.2A.

$$L_m = \frac{(L1 + L2)}{2} \qquad (4)$$

Die Berechnung kann in der Auswerte- und Steuereinheit 10 erfolgen. Bei dem dargestellten zweiten Ausführungsbeispiel sind die beiden Teilspulen 42.1A, 42.2A, 44.1A, 44.2A, 46.1A, 46.2A der Detektionsspulen 42A, 44A, 46A elektrisch in Reihe geschaltet. Da die Kopplungsfaktoren zwischen den Teilspulen 42.1A, 42.2A, 44.1A, 44.2A, 46.1A, 46.2A mit k<0,02 verhältnismäßig klein sind, addieren sich die Induktivitäten. Die Mittelwertbildung erfolgt somit quasi "analog" ohne Rechenaufwand. Des Weiteren reduziert sich die Anzahl der Anschlüsse zwischen der Spulenanordnung 40A und der Auswerte- und Steuereinheit 10. Zur Reduzierung der Störempfindlichkeit und zur Reduzierung der Feldemission sind die Teilspulen 42.1A, 42.2A, 44.1A, 44.2A, 46.1A, 46.2A, wie oben bereits ausgeführt, jeweils gegensinnig gewickelt. Dadurch reduziert sich die magnetische Feldstärke im Fernfeld. Bei Unterstellung eines homogenen Störfeldes werden in beide Teilspulen 42.1A, 42.2A, 44.1A, 44.2A, 46.1A, 46.2A gleiche Spannungen mit jeweils unterschiedlichem Vorzeichen induziert. Aufgrund der Reihenschaltung kompensieren sich beide Spannungen im Idealfall zu Null.

Wie aus Fig. 7 weiter ersichtlich ist, weisen Leiterbahnen L mit der Dicke B, welche die jeweilige Wicklung der Teilspulen 42.1A, 42.2A, 44.1A, 44.2A, 46.1A, 46.2A der Detektionsspulen 42A, 44A, 46A ausbilden, von denen beispielhaft eine erste Teilspule 42.1A der ersten Detektionsspule 42A dargestellt ist, analog zum ersten Ausführungsbeispiel kreisbogenförmige Leiterbahnabschnitte $L_B$ und radial verlaufende Leiterbahnabschnitte $L_R$ auf. Ein Abstand $d_K$, welchen die kreisbogenförmig verlaufenden Leiterbahnabschnitte $L_R$ zueinander haben, ist vorzugsweise möglichst klein gewählt, um möglichst viele Spulenwindungen N auf der zur Verfügung stehenden Fläche der Teilspule 42.1A, 42.2A, 44.1A, 44.2A, 46.1A, 46.2A. Die maximale Anzahl N der Spulenwindungen kann näherungsweise mit der Gleichung (1) berechnet werden. Analog zum ersten Ausführungsbeispiel betragen sowohl die minimale Leiterbahnbreite B als auch der minimale Abstand $d_K$ zwischen zwei kreisbogenförmigen Leiterbahnabschnitte $L_B$ beispielsweise 125 $\mu$m. Die Werte für die übrigen Größen betragen beispielsweise $r_a$ = 8,35 mm, $r_i$ = 4 mm und $r_m$ = 0,75 mm. Daraus folgt analog zum ersten Ausführungsbeispiel eine Windungszahl von N = 7,7 für die Teilspulen 42.1A, 42.2A, 44.1A, 44.2A, 46.1A, 46.2A.

Analog zum ersten Ausführungsbeispiel ist der Abstand $d_R$ der radial verlaufenden Leiterbahnabschnitte $L_R$ so gewählt, dass sich die radial verlaufenden Leiterbahnabschnitte $L_R$ möglichst gleichmäßig über die gesamte zur Verfügung stehende Fläche der korrespondierenden Teilspule 42.1A, 42.2A, 44.1A, 44.2A, 46.1A, 46.2A verteilen. Der passende Leiterbahnabstand $d_R$ lässt sich ebenfalls mit Gleichung (2) näherungsweise berechnen. Im dargestellten zweiten Ausführungsbeispiel beträgt der Abstand $d_R$ beispielsweise 230 $\mu$m. Zudem gilt im dargestellten zweiten Ausführungsbeispiel der Spulenanordnung 40A: $\vartheta$ = 60° und $\alpha$ = 50°.

Wie aus dem zugehörigen Kennliniendiagramm gemäß Fig. 8 ersichtlich ist, verlaufen die drei erzeugten phasenverschobenen Auswertesignale K1A, K2A, K3A analog zum ersten Ausführungsbeispiel nahezu sinusförmig, wobei die Auswerte- und Steuereinheit 10 ein erstes Auswertesignal K1A durch Auswerten der ersten Detektionsspule 42A mit den Teilspulen 42.1A und 42.2A erzeugt, ein zweites Auswertesignal K2A durch Auswerten der zweiten Detektionsspule 44A mit den Teilspulen 44.1A und 44.2A erzeugt und ein drittes Auswertesignal K3A durch Auswerten der dritten Detektionsspule 46A mit den Teilspulen 46.1A und 46.2A erzeugt. Des Weiteren besteht eine Symmetrie zwischen den Teilspulen 42.1A und 42.2A, 44.1A und 44.2A sowie 46.1A und 46.2A. Bei exakt mittiger Lage des Targets 20A gegenüber der Spulenanordnung 40A gibt es keine Unterschiede zwischen den jeweiligen Partnern und den Auswertesignalen K1A, K2A, K3A. Der Drehwinkelmessbereich beträgt durch die Verwendung von vier Metallflächen 24A 90°. Analog zum Kennliniendiagramm gemäß Fig. 4, ist in dem in Fig. 8 dargestellten Kennliniendiagramm entlang der senkrechten Achse eine Resonanzfrequenz aufgetragen, welche sich durch die Induktivitätsänderung der jeweiligen Detektionsspule 42A, 44A, 46A verändert. Selbstverständlich können auch andere geeignete messbare physikalische Größen verwendet werden, um Induktivitätsänderung der jeweiligen Detektionsspule 42A, 44A, 46A zu erfassen und darzustellen.

**Patentansprüche**

1. Sensoranordnung zur berührungslosen Erfassung von Drehwinkeln an einem rotierenden Bauteil, wobei das rotierende Bauteil mit einem scheibenförmigen Target (20) gekoppelt ist, welches mindestens zwei Metallflächen (24) aufweist und in Verbindung mit einer Spulenanordnung (40), welche drei flächige Detektionsspulen (42, 44, 46) aufweist, mindestens eine Information zur Ermittlung des aktuellen Drehwinkels des rotierenden Bauteils erzeugt, wobei die drei flächigen Detektionsspulen (42, 44, 46) gleichmäßig verteilt am Umfang eines Kreises angeordnet sind, und die mindestens zwei Metallflächen (24) durch Wirbelstromeffekte die Induktivitäten der flächigen Detektionsspulen (42, 44, 46) in Abhängigkeit vom Überdeckungsgrad beeinflussen, wobei eine Auswerte- und Steuereinheit (10) im Wesentlichen sinusförmige Auswertesignale (K1, K2, K3), welche die Induktivitätsänderungen der Detektionsspulen (42, 44, 46) repräsentieren, erzeugt und zur Berechnung des Drehwinkels auswertet, **dadurch gekennzeichnet, dass** die flächigen Detektionsspulen (42, 44, 46) jeweils als gleichförmige Kreissegmente und/oder Kreisringsegmente mit einem vorgegebenen Öffnungswinkel im Bereich von 100° bis 120° ausgeführt sind.

2. Sensoranordnung zur berührungslosen Erfassung von Drehwinkeln an einem rotierenden Bauteil, wobei das rotierende Bauteil mit einem scheibenförmigen Target (20A) gekoppelt ist, welches mindestens vier Metallflächen (24A) aufweist und in Verbindung mit einer Spulenanordnung (40A), welche drei flächige Detektionsspulen (42A, 44A, 46A) aufweist, mindestens eine Information zur Ermittlung des aktuellen Drehwinkels des rotierenden Bauteils erzeugt, wobei die drei flächigen Detektionsspulen (42A, 44A, 46A) gleichmäßig verteilt am Umfang eines Kreises angeordnet sind, wobei die mindestens vier Metallflächen (24A) durch Wirbelstromeffekte die Induktivitäten der flächigen Detektionsspulen (42A, 44A, 46A) in Abhängigkeit vom Überdeckungsgrad beeinflussen, wobei eine Auswerte- und Steuereinheit (10) im Wesentlichen sinusförmige Auswertesignale (K1A, K2A, K3A), welche die Induktivitätsänderungen der Detektionsspulen (42A, 44A, 46A) repräsentieren, erzeugt und zur Berechnung des Drehwinkels auswertet, wobei die flächigen Detektionsspulen (42A, 44A, 46A) jeweils zwei Teilspulen (42.1A, 42.2A, 44.1A, 44.2A, 46.1A, 46.2A) aufweisen, welche einander gegenüberliegend am Umfang des Kreises angeordnet sind, **dadurch gekennzeichnet, dass** die beiden Teilspulen (42.1A, 42.2A, 44.1A, 44.2A, 46.1A, 46.2A) jeweils einen entgegengesetzten Wicklungssinn aufweisen und als gleichförmige Kreissegmente und/oder Kreisringsegmente mit einem vorgegebenen Öffnungswinkel im Bereich von 50° bis 60° ausgeführt sind.

3. Sensoranordnung nach einem der Ansprüche 1 oder 2, **dadurch gekennzeichnet, dass** ein Abstand ($d_K$) zwischen zwei kreisbogenförmig verlaufenden Leiterbahnabschnitten ($L_B$) der einzelnen Detektionsspulen (42, 44, 46) oder Teilspulen (42.1A, 42.2A, 44.1A, 44.2A, 46.1A, 46.2A) möglichst klein und ein Abstand ($d_R$) zwischen zwei radial verlaufenden Leiterbahnabschnitten ($L_R$) der einzelnen Detektionsspulen (42, 44, 46) oder Teilspulen (42.1A, 42.2A, 44.1A, 44.2A, 46.1A, 46.2A) so gewählt ist, dass sich die radial verlaufenden Leiterbahnabschnitte ($L_R$) möglichst gleichmäßig über die zu Verfügung stehende Fläche der einzelnen Detektionsspulen (42, 44, 46) oder Teilspulen (42.1A, 42.2A, 44.1A, 44.2A, 46.1A, 46.2A) verteilen.

4. Sensoranordnung nach einem der Ansprüche 1 bis 3, **dadurch gekennzeichnet, dass** die Metallflächen (24, 24A) jeweils als gleichförmige Kreissegmente und/oder Kreisringsegmente mit einem vorgegebenen Öffnungswinkel ausgeführt sind.

5. Sensoranordnung nach einem der Ansprüche 1, 3 oder 4, **dadurch gekennzeichnet, dass** das Target (20) zwei einander gegenüberliegende am Umfang eines Kreises angeordnete Metallflächen (24) aufweist, welche jeweils einen Öffnungswinkel mit einem Wert im Bereich von 100° bis 120° aufweisen.

6. Sensoranordnung nach einem der Ansprüche 2-4 **dadurch gekennzeichnet, dass** das Target (20A) vier gleichmäßig verteilt am Umfang eines Kreises angeordnete Metallflächen (24A) aufweist, welche jeweils einen Öffnungswinkel mit einem Wert im Bereich von 50° bis 60° aufweisen.

**Claims**

1. Sensor arrangement for the contactless sensing of angles of rotation on a rotating part, wherein the rotating part is coupled with a disk-shaped target (20) which has at least two metal surfaces (24), and which generates at least one piece of information for ascertaining the instantaneous angle of rotation of the rotating part, in connection with a coil arrangement (40) which has three flat detection coils (42, 44, 46), wherein the three flat detection coils (42, 44, 46) are uniformly distributed on the circumference of a circle, and the at least two metal surfaces (24) influence the inductances in the flat detection coils (42, 44, 46) due to eddy current effects, as a function of the degree of overlap, wherein an evaluation and control unit (10) generates essentially sinusoidal evaluation signals (K1, K2, K3) which represent the changes in inductance of the detection coils (42, 44, 46), and evaluates them for calculating the angle of rotation, **characterized in that** the flat detection coils (42, 44, 46) are each designed as uniform circle segments and/or annular segments having a predefined opening angle in the range of 100° to 120°

2. Sensor arrangement for the contactless sensing of angles of rotation on a rotating part, wherein the rotating part is coupled with a disk-shaped target (20A) which has at least four metal surfaces (24A), and which generates at least one piece of information for ascertaining the instantaneous angle of rotation of the rotating part, in connection with a coil arrangement (40A) which has three flat detection coils (42A, 44A, 46A), wherein the three flat detection coils (42A, 44A, 46A) are uniformly distributed on the circumference of a circle, wherein the at least four metal surfaces (24A) influence the inductances in the flat detection coils (42A, 44A, 46A) due to eddy current effects, as a function of the degree of overlap, wherein an evaluation and control unit (10) generates essentially sinusoidal evaluation signals (1A, K2A, K3A) which represent the changes in inductance of the detection coils (42A, 44A, 46A), and evaluates them for calculating the angle of rotation, wherein the flat detection coils (42A, 44A, 46A) each have two coil sections (42.1A, 42.2A, 44.1A, 44.2A, 46.1A, 46.2A) which are arranged opposite one another on the circumference of the circle, **characterized in that** the two coil sections (42.1A, 42.2A, 44.1A, 44.2A, 46.1A, 46.2A) each have an opposite winding sense and are designed as uniform circle segments and/or annular segments having a predefined opening angle in the range of 50° to 60° in each case.

3. Sensor arrangement according to either of Claims 1 and 2, **characterized in that** a spacing ($d_K$) between two conducting path sections ($L_B$), which extend in a circular arc shape, of the individual detection coils (42, 44, 46) or coil sections (42.1A, 42.2A, 44.1A, 44.2A, 46.1A, 46.2A), is as small as possible, and a spacing ($d_R$) between two radially extending conducting path sections ($L_R$) of the individual detection coils (42, 44, 46) or coil sections (42.1A, 42.2A, 44.1A, 44.2A, 46.1A, 46.2A) is chosen in such a way that the radially extending conducting path sections ($L_R$) are distributed as uniformly as possible over the available surface of the individual detection coils (42, 44, 46) or coil sections (42.1A, 42.2A, 44.1A, 44.2A, 46.1A, 46.2A).

4. Sensor arrangement according to one of Claims 1 to 3, **characterized in that** the metal surfaces (24, 24A) are each designed as uniform circle segments and/or annular segments having a predefined opening angle.

5. Sensor arrangement according to one of Claims 1, 3 or 4, **characterized in that** the target (20) has two metal surfaces (24) arranged opposite one another on the circumference of a circle, each having an opening angle with a value in the range of 100° to 120°.

6. Sensor arrangement according to one of Claims 2 to 4, **characterized in that** the target (20A) has four metal surfaces (24A) which are arranged uniformly distributed on the circumference of a circle, each having an opening angle with a value in the range of 50° to 60°.

**Revendications**

1. Arrangement détecteur destiné à détecter sans contact des angles de rotation sur un élément structural en rotation, l'élément structural en rotation étant couplé avec une cible (20) en forme de disque qui possède au moins deux surfaces métalliques (24) et qui, en association avec un arrangement de bobines (40) qui possède trois bobines de détection (42, 44, 46) plates, génère au moins une information destinée à la détermination de l'angle de rotation actuel de l'élément structural en rotation, les trois bobines de détection (42, 44, 46) plates étant distribuées uniformément sur le pourtour d'un cercle et les au moins deux surfaces métalliques (24), par des effets de courant de Foucault, influençant les inductances des bobines de détection (42, 44, 46) plates en fonction du degré de recouvrement, une unité d'interprétation et de commande (10) générant des signaux d'interprétation (K1, K2, K3) sensiblement sinusoïdaux qui représentent les variations d'inductance des bobines de détection (42, 44, 46) et les interprétant en vue de calculer l'angle de rotation, **caractérisé en ce que** les bobines de détection (42, 44, 46) plates sont respectivement réalisées sous la forme de segments de cercle et/ou de segments d'anneau circulaire de forme identique avec un angle d'ouverture prédéfini dans la plage de 100° à 120°.

2. Arrangement détecteur destiné à détecter sans contact des angles de rotation sur un élément structural en rotation, l'élément structural en rotation étant couplé avec une cible (20A) en forme de disque qui possède au moins quatre surfaces métalliques (24A) et qui, en association avec un arrangement de bobines (40A) qui possède trois bobines de détection (42A, 44A, 46A) plates, génère au moins une information destinée à la détermination de l'angle de rotation actuel de l'élément structural en rotation, les trois bobines de détection (42A, 44A, 46A) plates étant distribuées uniformément sur le pourtour d'un cercle, les au moins quatre surfaces métalliques (24A), par des effets de courant de Foucault, influençant les inductances des bobines de détection (42A, 44A, 46A) plates en fonction du degré de recouvrement, une unité d'interprétation et de commande (10) générant des signaux d'interprétation (K1A, K2A, K3A) sensiblement sinusoïdaux qui représentent les variations d'inductance des bobines de détection (42A, 44A, 46A) et les interprétant en vue de calculer l'angle de rotation, les bobines de détection (42A, 44A, 46A) plates possédant respectivement deux bobines partielles (42.1A, 42.2A, 44.1A, 44.2A, 46.1A, 46.2A) qui sont disposées les unes en face des autres sur le pourtour du cercle, **caractérisé en ce que** les deux bobines partielles (42.1A, 42.2A, 44.1A, 44.2A, 46.1A, 46.2A) possèdent respectivement un sens d'enroulement opposé et sont réalisées sous la forme de segments de cercle et/ou de segments d'anneau circulaire de forme identique avec un angle d'ouverture prédéfini dans la plage de 50° à 60°.

3. Arrangement détecteur selon l'une des revendications 1 et 2, **caractérisé en ce qu'**un écart ($d_K$) entre deux portions de piste conductrice ($L_B$) suivant un tracé en arc de cercle des bobines de détection (42, 44, 46) ou des bobines partielles (42.1A, 42.2A, 44.1A, 44.2A, 46.1A, 46.2A) individuelles est choisi le plus petit possible et un écart ($d_R$) entre deux portions de piste conductrice ($L_R$) suivant un tracé radial des bobines de détection (42, 44, 46) ou des bobines partielles (42.1A, 42.2A, 44.1A, 44.2A, 46.1A, 46.2A) individuelles est choisi de telle sorte que les portions de piste conductrice ($L_R$) suivant un tracé radial se distribuent aussi régulièrement que possible sur la surface disponible des bobines de détection (42, 44, 46) ou des bobines partielles (42.1A, 42.2A, 44.1A, 44.2A, 46.1A, 46.2A) individuelles.

4. Arrangement détecteur selon l'une des revendications 1 à 3, **caractérisé en ce que** les surfaces métalliques (24, 24A) sont respectivement réalisées sous la forme de segments de cercle et/ou de segments d'anneau circulaire de forme identique avec un angle d'ouverture prédéfini.

5. Arrangement détecteur selon l'une des revendications 1, 3 et 4, **caractérisé en ce que** la cible (20) possède deux surfaces métalliques (24) disposées en face l'une de l'autre sur le pourtour d'un cercle, lesquelles possèdent respectivement un angle d'ouverture ayant une valeur dans la plage de 100° à 120°.

6. Arrangement détecteur selon l'une des revendications 2 à 4, **caractérisé en ce que** la cible (20A) possède quatre surfaces métalliques (24A) distribuées uniformément sur le pourtour d'un cercle, lesquelles possèdent respectivement un angle d'ouverture ayant une valeur dans la plage de 50° à 60°.

**FIG. 1**

**FIG. 2**

**FIG. 3**

**FIG. 4**

FIG. 5

FIG. 6

**FIG. 7**

**FIG. 8**

**IN DER BESCHREIBUNG AUFGEFÜHRTE DOKUMENTE**

**In der Beschreibung aufgeführte Patentdokumente**

- DE 19738836 A1
- EP 1975570 A2
- EP 1083408 A2
- DE 102007037217 A1
- DE 9105145 U1